# EUROPEAN PATENT APPLICATION

(11) **EP 3 336 885 A1**
(43) Date of publication of application: **20.06.2018**
(21) Application number: 16834383.8
(22) Date of filing: 05.01.2016
(51) Int. Cl.: H01L 21/77, H01L 21/768

(54) **ARRAY SUBSTRATE AND PRODUCTION METHOD THEREFOR, DISPLAY PANEL, AND DISPLAY APPARATUS**

(30) Priority: 13.08.2015 CN 201510497522
(71) Applicant: BOE Technology Group Co., Ltd., Beijing 100015 (CN); Hefei BOE Optoelectronics Technology Co., Ltd., Hefei, Anhui 230012 (CN)
(72) Inventor: LI, Zhenfang, Beijing 100176 (CN); YANG, Xiaoyu, Beijing 100176 (CN); KWON, Kiyoung, Beijing 100176 (CN); LUO, Qiangqiang, Beijing 100176 (CN)
(74) Representative: Potter Clarkson LLP
(86) International application number: PCT/CN2016/070120
(87) International publication number: WO 2017/024755

(57) **Abstract**

The present disclosure provides an array substrate and a method for manufacturing the same, a display panel, and a display device. The method includes: forming a first conductive pattern and a second conductive pattern on a base substrate; forming a via hole on the base substrate formed with the first conductive pattern and the second conductive pattern, and a lateral side of the via hole being half opened; and forming a jumper wire film on the base substrate formed with the via hole.

## Description

### CROSS REFERENCE

The present application is based upon and claims priority to Chinese Patent Application No. 201510497522.1, filed on August 13, 2015, and the entire contents thereof are incorporated herein by reference.

### TECHNICAL FIELD

The present disclosure relates to the field of display technology, in particular, to an array substrate and a method for manufacturing the same, a display panel and a display device.

### BACKGROUND

A thin-film transistor liquid crystal display (TFT-LCD) is one type of liquid crystal displays (LCDs). During the manufacturing of the thin-film transistor (TFT) array substrate, a jumper wire film (e.g., an indium tin oxide (ITO) film) and a via hole may be required to connect metal patterns in different layers for signal transmission. For example, the gate metal pattern and the source/drain metal pattern may be connected through an ITO film to transmit the gate signal and the common electrode (Com) signal.

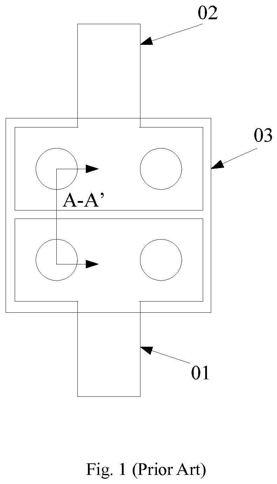

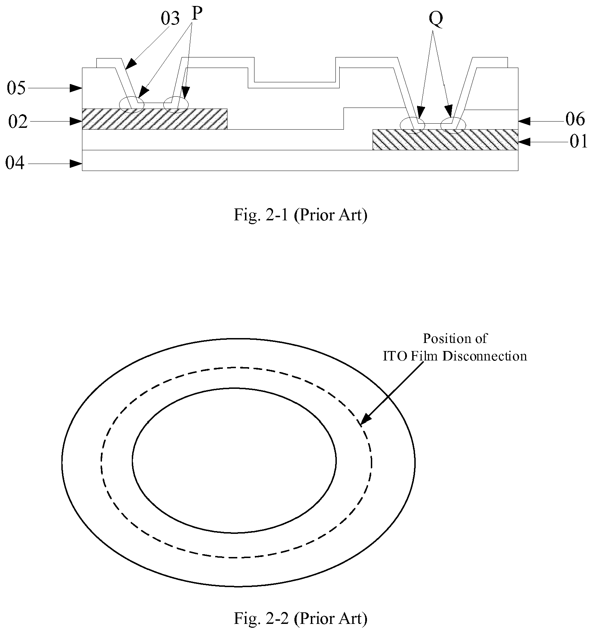

In the related art, during the formation of the via hole, since the insulation pattern on the gate metal pattern (i.e., the gate insulation pattern) has a different thickness from the insulation pattern on the source/drain metal pattern (i.e., the passivation pattern), the via hole may be formed by over etching to ensure that the insulation pattern within the via hole may be etched completely. Generally, the over etching may refer to etching additional 30-50% on the basis of an initial etching process. Fig. 1 illustrates a plan view of a via hole structure of an array substrate. Fig. 1 illustrates a gate metal pattern 01, a source/drain metal pattern 02 and an ITO film 03. Fig. 2-1 illustrates a cross sectional view taken along a part A-A' of the array substrate illustrated in Fig. 1. Fig. 2-1 illustrates a base substrate 04, a source/drain metal pattern 02, a passivation layer pattern 05, an ITO film 03, a gate insulation pattern 06 and a gate metal pattern 01.

The via hole formed by the above method generally has a diameter of 10 µm. The via hole is formed with a smaller opening and is a blind hole, and thus the over etching may partly etch a part of the insulation pattern at the position where the metal pattern contacts the insulation pattern, causing a relative high risk of undercut. As illustrated in Fig. 2-1, the over etching may etch a part of the passivation layer pattern 05 at a position P or a part of the gate insulation pattern 06 at a position Q. In this case, the ITO film 03 at the corner of the via hole may be not well connected, thereby causing abnormal signal transmission. Fig. 2-2 further illustrates a plan view of the via hole on the array substrate, wherein the position of ITO film disconnection is marked with a dashed line. The above problem may cause a deterioration of the display quality of the array substrate.

### SUMMARY

In order to overcome the problem of display quality deterioration of the array substrate, the present disclosure provides an array substrate and a method for manufacturing the same, a display panel and a display device. The technical solution is as follow.

In a first aspect, there is provided a method for manufacturing an array substrate, including:
forming a first conductive pattern and a second conductive pattern on a base substrate;
forming a via hole on the base substrate formed with the first conductive pattern and the second conductive pattern, and a lateral side of the via hole being half opened; and
forming a jumper wire film on the base substrate formed with the via hole.

Optionally, the via hole is a bar shaped hole, and a lateral side in a length direction or a width direction of the bar shaped hole is opened.

Optionally, a size of the bar shaped hole along a direction of the lateral side that is opened is equal to or greater than 15 µm and equal to or smaller than 20 µm.

Optionally, the method further includes:
forming the first conductive pattern on the base substrate;
forming a first insulation layer pattern on the base substrate formed with the first conductive pattern;
forming the second conductive pattern on the base substrate formed with the first insulation layer pattern, the second conductive pattern and the first conductive pattern being disposed in different layers on the base substrate;
forming a second insulation layer pattern on the base substrate formed with the second conductive pattern;
forming the via hole by encirclement of the first conductive pattern, the second conductive pattern, the first insulation layer pattern and the second insulation layer pattern; and
forming the jumper wire film on the base substrate formed with the via hole to electrically connect the first conductive pattern and the second conductive pattern.

Optionally, the first conductive pattern is a gate metal pattern, and the second conductive pattern is a source/drain metal pattern,
wherein the forming a first insulation layer pattern on the base substrate formed with the first conductive pattern includes:
forming a gate insulation layer on the base substrate formed with the gate metal pattern; and
patterning the gate insulation layer to form a gate insulation pattern,
wherein the forming a second conductive pattern on the base substrate formed with the first insulation layer pattern includes:
forming the source/drain metal pattern on the base substrate formed with the gate insulation pattern,
wherein the forming a second insulation layer pattern on the base substrate formed with the second conductive pattern includes:
forming a passivation layer on the base substrate formed with the source/drain metal pattern; and
patterning the passivation layer to form a passivation layer pattern.

Optionally,
the gate insulation pattern includes a first sub pattern formed on the gate metal pattern and a second sub pattern formed in a same layer with the gate metal pattern, a gap is formed between the gate metal pattern and the second sub pattern, and the first sub pattern overlaps a part of the gate metal pattern away from the second sub pattern.

Optionally,
the source/drain metal pattern is formed in a same layer with the first sub pattern, and a gap is formed between the source/drain metal pattern and the first sub pattern.

Optionally,
the passivation layer pattern includes a third sub pattern formed on the first sub pattern and a fourth sub pattern formed on the source/drain metal pattern, the fourth sub pattern overlaps a part of the source/drain metal pattern away from the first sub pattern, and the via hole is formed by collective encirclement of a part of the gate metal pattern that is not overlapped with the first sub pattern of the gate insulation layer, a part of the source/drain metal pattern that is not overlapped with the fourth sub pattern of the passivation layer, the gate insulation pattern and the passivation layer pattern.

Optionally, the method further includes:
forming the first conductive pattern and the second conductive pattern on the base substrate, the second conductive pattern and the first conductive pattern being formed in a same layer on the base substrate;
forming a first insulation layer pattern on the base substrate formed with the first conductive pattern and the second conductive pattern;
forming the via hole by encirclement of the first conductive pattern, the second conductive pattern and the first insulation layer pattern; and
forming the jumper wire film on the base substrate formed with the via hole to electrically connect the first conductive pattern and the second conductive pattern.

Optionally, the first conductive pattern is a first gate metal pattern, the second conductive pattern is a second gate metal pattern, and the method further includes:
forming a gate metal thin film on the base substrate, and patterning the gate metal thin film to form the first gate metal pattern and the second gate metal pattern in a same layer;
forming a gate insulation layer on the base substrate formed with the first gate metal pattern and the second gate metal pattern;
patterning the gate insulation layer to form a gate insulation pattern, the gate insulation pattern overlapping a part of the first gate metal pattern away from the second gate metal pattern and overlapping a part of the second gate metal pattern away from the first gate metal pattern;
forming the via hole by collective encirclement of a part of the first gate metal pattern that is not overlapped with the gate insulation pattern, a part of the second gate metal pattern that is not overlapped with the gate insulation pattern, and the gate insulation pattern; and
forming the jumper wire film on the base substrate formed with the via hole to electrically connect the first gate metal pattern and the second gate metal pattern.

Optionally, the first conductive pattern is a first source/drain metal pattern, the second conductive pattern is a second source/drain metal pattern, and the method further includes:
forming a source/drain metal thin film on the base substrate, and patterning the source/drain metal thin film to form the first source/drain metal pattern and the second source/drain metal pattern in a same layer;
forming a passivation layer on the base substrate formed with the first source/drain metal pattern and the second source/drain metal pattern;
patterning the passivation layer to form a passivation layer pattern, the passivation layer pattern overlapping a part of the first source/drain metal pattern away from the second source/drain metal pattern and overlapping a part of the second source/drain metal pattern away from the first source/drain metal pattern;
forming the via hole by collective encirclement of a part of the first source/drain metal pattern that is not overlapped with the passivation layer pattern, a part of the second source/drain metal pattern that is not overlapped with the passivation layer pattern, and the passivation layer pattern; and
forming the jumper wire film on the base substrate formed with the via hole to electrically connect the first source/drain metal pattern and the second source/drain metal pattern.

In a second aspect, there is provided an array substrate including:
a base substrate;
a first conductive pattern and a second conductive pattern formed on the base substrate;
a via hole formed on the base substrate formed with the first conductive pattern and the second conductive pattern, and a lateral side of the via hole being half opened; and
a jumper wire film formed on the base substrate formed with the via hole.

Optionally, via hole is a bar shaped hole, and a lateral side in a length direction or a width direction of the bar shaped hole is opened.

Optionally, a size of the bar shaped hole along a direction of the lateral side that is opened is equal to or greater than 15 µm and equal to or smaller than 20 µm.

Optionally,
the first conductive pattern is formed on the base substrate;
a first insulation layer pattern is formed on the base substrate formed with the first conductive pattern;
the second conductive pattern is formed on the base substrate formed with the first insulation layer pattern, the second conductive pattern and the first conductive pattern being disposed in different layers on the base substrate;
a second insulation layer pattern is formed on the base substrate formed with the second conductive pattern;
the via hole is formed by encirclement of the first conductive pattern, the second conductive pattern, the first insulation layer pattern and the second insulation layer pattern; and
the jumper wire film is formed on the base substrate formed with the via hole to electrically connect the first conductive pattern and the second conductive pattern.

Optionally, the first conductive pattern is a gate metal pattern, and the second conductive pattern is a source/drain metal pattern,
a gate insulation pattern is formed on the base substrate formed with the gate metal pattern;
the source/drain metal pattern is formed on the base substrate formed with the gate insulation pattern; and
a passivation layer pattern is formed on the base substrate formed with the source/drain metal pattern.

Optionally,
the gate insulation pattern includes a first sub pattern formed on the gate metal pattern and a second sub pattern formed in a same layer with the gate metal pattern, a gap is formed between the gate metal pattern and the second sub pattern, and the first sub pattern overlaps a part of the gate metal pattern away from the second sub pattern.

Optionally,
the source/drain metal pattern is formed in a same layer with the first sub pattern, and a gap is formed between the source/drain metal pattern and the first sub pattern.

Optionally,
the passivation layer pattern includes a third sub pattern formed on the first sub pattern and a fourth sub pattern formed on the source/drain metal pattern, the fourth sub pattern overlaps a part of the source/drain metal pattern away from the first sub pattern, and the via hole is formed by collective encirclement of a part of the gate metal pattern that is not overlapped with the first sub pattern of the gate insulation layer, a part of the source/drain metal pattern that is not overlapped with the fourth sub pattern of the passivation layer, the gate insulation pattern and the passivation layer pattern.

Optionally,
the first conductive pattern and the second conductive pattern are formed on the base substrate, and the second conductive pattern and the first conductive pattern are formed in a same layer on the base substrate;
a first insulation layer pattern is formed on the base substrate formed with the first conductive pattern and the second conductive pattern;
the via hole is formed by encirclement of the first conductive pattern, the second conductive pattern and the first insulation layer pattern; and
the jumper wire film is formed on the base substrate formed with the via hole to electrically connect the first conductive pattern and the second conductive pattern.

Optionally, the first conductive pattern is a first gate metal pattern, and the second conductive pattern is a second gate metal pattern,
the first gate metal pattern and the second gate metal pattern are formed on the base substrate;
a gate insulation pattern is formed on the base substrate formed with the first gate metal pattern and the second gate metal pattern, the gate insulation pattern overlaps a part of the first gate metal pattern away from the second gate metal pattern and overlaps a part of the second gate metal pattern away from the first gate metal pattern;
the via hole is formed by collective encirclement of a part of the first gate metal pattern that is not overlapped with the gate insulation pattern, a part of the second gate metal pattern that is not overlapped with the gate insulation pattern, and the gate insulation pattern; and
the jumper wire film is formed on the base substrate formed with the via hole to electrically connect the first gate metal pattern and the second gate metal pattern.

Optionally, the first conductive pattern is a first source/drain metal pattern, and the second conductive pattern is a second source/drain metal pattern,
the first source/drain metal pattern and the second source/drain metal pattern are formed on the base substrate;
a passivation layer pattern is formed on the base substrate formed with the first source/drain metal pattern and the second source/drain metal pattern, and the passivation layer pattern overlaps a part of the first source/drain metal pattern away from the second source/drain metal pattern and overlaps a part of the second source/drain metal pattern away from the first source/drain metal pattern; the via hole is formed by collective encirclement of a part of the first source/drain metal pattern that is not overlapped with the passivation layer pattern, a part of the second source/drain metal pattern that is not overlapped with the passivation layer pattern, and the passivation layer pattern; and
the jumper wire film is formed on the base substrate formed with the via hole to electrically connect the first source/drain metal pattern and the second source/drain metal pattern.

In a third aspect, there is provided a display panel including an array substrate according to any one of the second aspect.

In a fourth aspect, there is provided a display device including a display panel according to the third aspect.

The present disclosure provides an array substrate and a method for manufacturing the same, a display panel and a display device. According to the present disclosure, it is possible to form a first conductive pattern and a second conductive pattern on a base substrate, form a via hole having a half opened lateral side on the base substrate formed with the first conductive pattern and the second conductive pattern, and form a jumper wire film on the base substrate formed with the via hole, thereby connecting the conductive patterns in different layers or the same layer using the jumper wire film. In comparison to the related art, it is possible to ensure a complete connection of the jumper wire film and a normal transmission of the signal, thereby improving display quality of the array substrate.

It is to be understood that both the foregoing general description and the following detailed description are exemplary and explanatory only and are not restrictive of the present disclosure.

### BRIEF DESCRIPTION OF THE DRAWINGS

In order to clearly describe implementations of the embodiments of the present disclosure, the accompanying drawings to be used for describing the embodiments are briefly introduced hereinafter. Obviously, the accompanying drawings described hereinafter are merely embodiments of the present disclosure, and other drawings are possible to those ordinary skilled in the art without creative work.
Fig. 1 is a structural schematic view of an array substrate in the related art;
Fig. 2-1 is a cross sectional view taken along a part A-A' of the array substrate illustrated in Fig. 1;
Fig. 2-2 is a plan view of the array substrate illustrated in Fig. 2-1;
Fig. 3 is a flow chart illustrating a method for manufacturing an array substrate according to some embodiments of the present disclosure;
Fig. 4-1 is a flow chart illustrating a method for manufacturing an array substrate according to some embodiments of the present disclosure;
Fig. 4-2 is a structural schematic view of the array substrate corresponding to Fig. 4-1;
Fig. 5-1 is a flow chart illustrating a method for manufacturing an array substrate according to some embodiments of the present disclosure;
Fig. 5-2 is a structural schematic view of forming the gate metal pattern according to embodiments of the present disclosure;
Fig. 5-3 is a structural schematic view of forming the gate insulation layer according to embodiments of the present disclosure;
Fig. 5-4 is a structural schematic view of forming the gate insulation pattern according to embodiments of the present disclosure;
Fig. 5-5 is a structural schematic view of forming the source/drain metal pattern according to embodiments of the present disclosure;

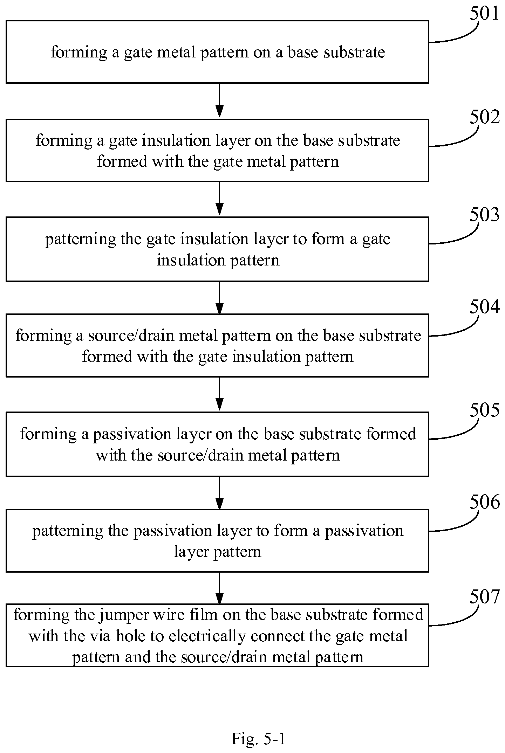

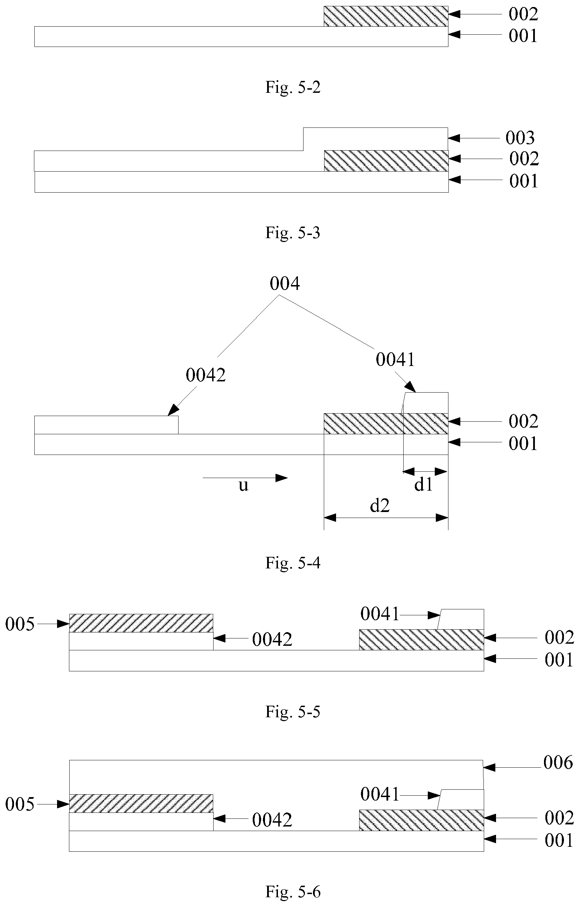

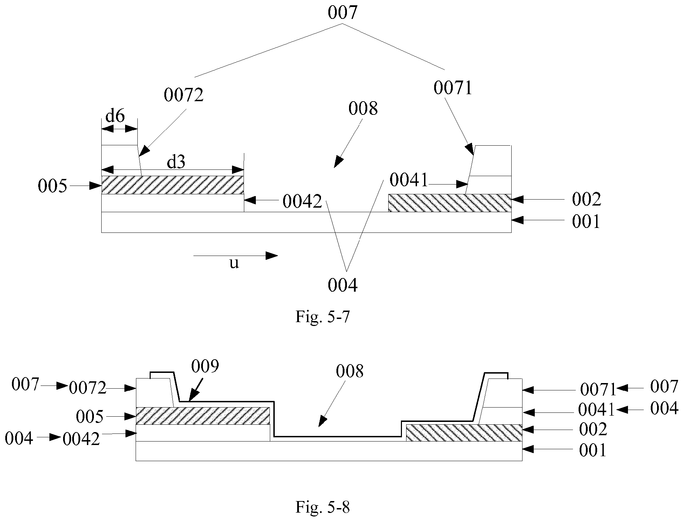

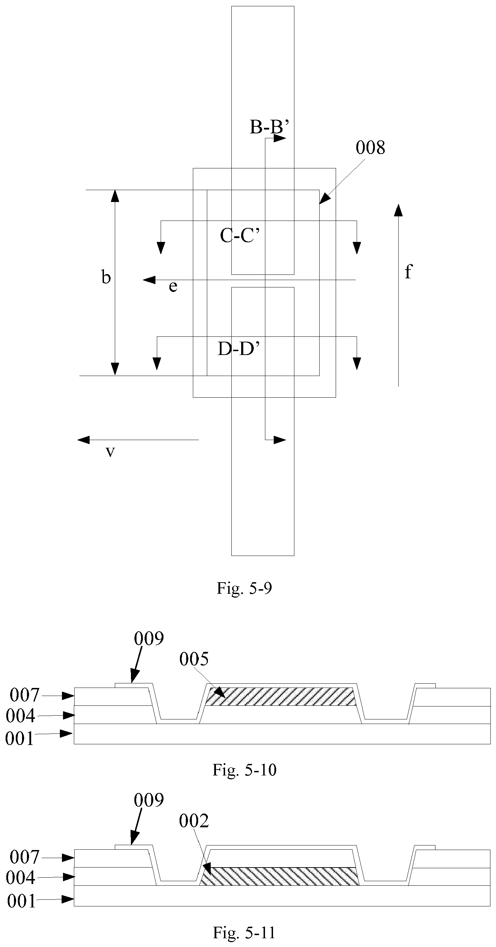

Fig. 5-6 is a is structural schematic view of forming the passivation layer according to embodiments of the present disclosure;
Fig. 5-7 is a is structural schematic view of forming the passivation layer pattern according to embodiments of the present disclosure;
Fig. 5-8 is a structural schematic view of forming the jumper wire film according to embodiments of the present disclosure;
Fig. 5-9 is a plan view of the via hole according to embodiments of the present disclosure;
Fig. 5-10 is a cross sectional view taken along a part C-C' of the array substrate illustrated in Fig. 5-9;
Fig. 5-11 is a cross sectional view taken along a part D-D' of the array substrate illustrated in Fig. 5-9;

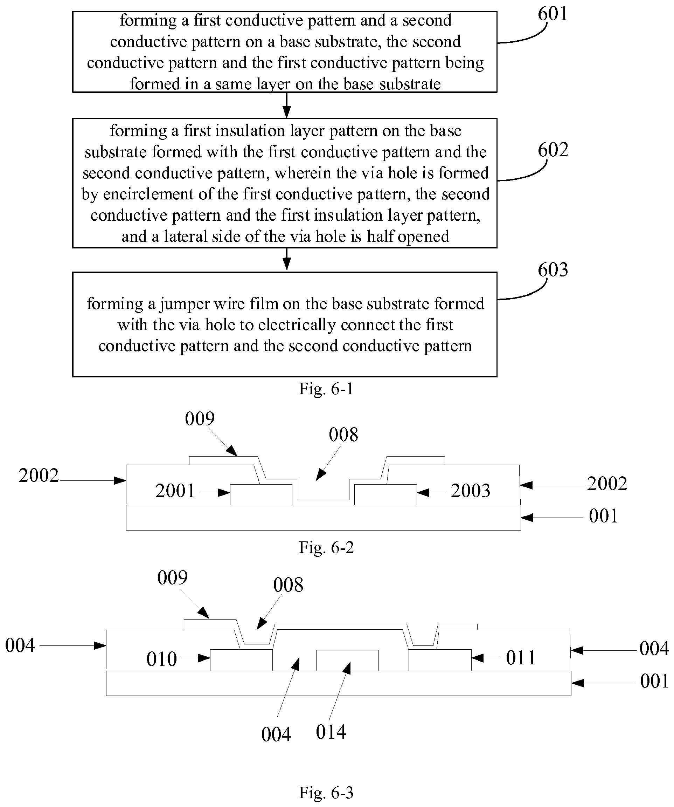

Fig. 6-1 is a flow chart illustrating a method for manufacturing an array substrate according to some embodiments of the present disclosure;
Fig. 6-2 is a structural schematic view of some array substrates corresponding to Fig. 6-1;
Fig. 6-3 is a structural schematic view of some array substrates corresponding to Fig. 6-1;

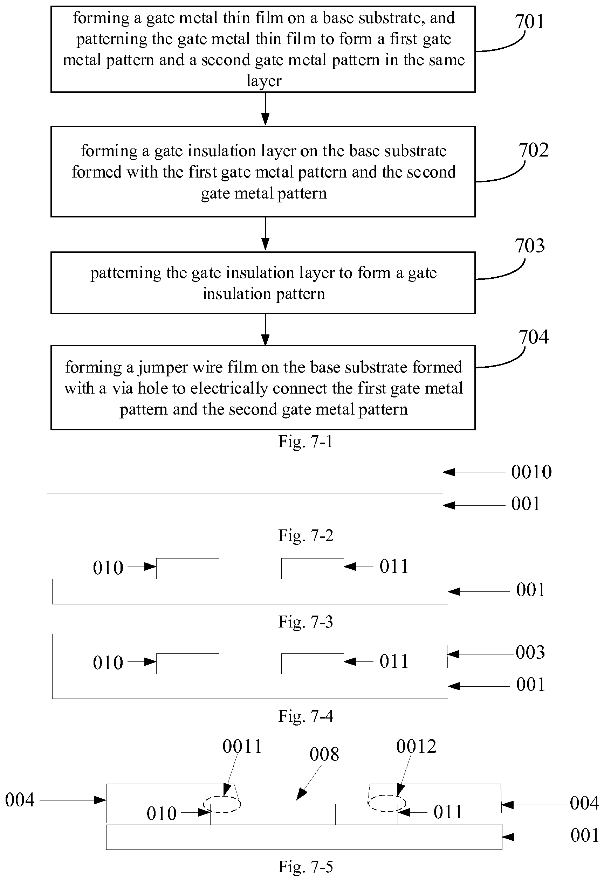

Fig. 7-1 is a flow chart illustrating a method for manufacturing an array substrate according to some embodiments of the present disclosure;
Fig 7-2 is a structural schematic view of forming the gate metal thin film according to embodiments of the present disclosure;
Fig 7-3 is a structural schematic view of forming the first gate metal pattern and the second gate metal pattern according to embodiments of the present disclosure;
Fig. 7-4 is a structural schematic view of forming the gate insulation layer according to some embodiments of the present disclosure;
Fig. 7-5 is a structural schematic view of forming the gate insulation pattern according to some embodiments of the present disclosure;

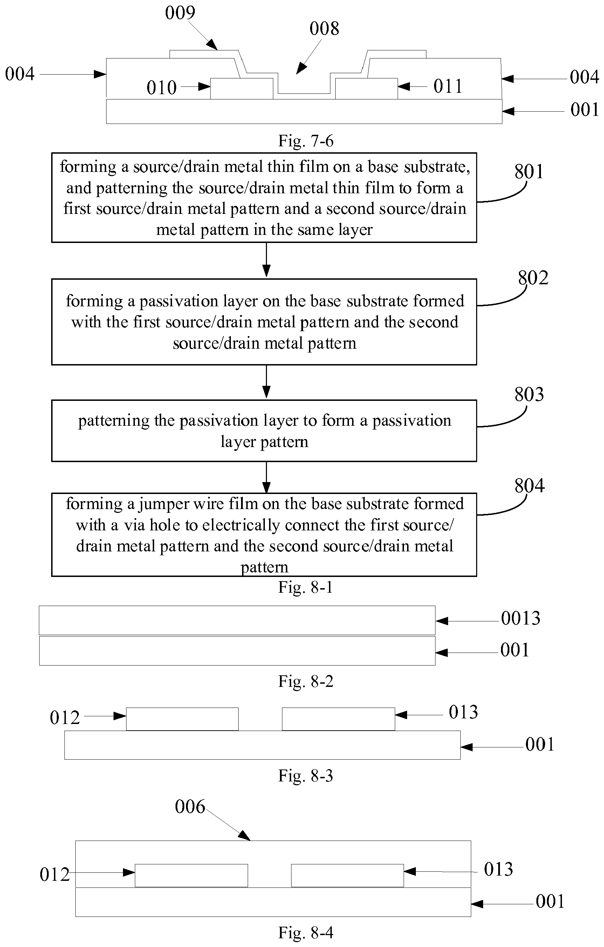

Fig. 7-6 is a structural schematic view of forming the jumper wire film according to some embodiments of the present disclosure;
Fig. 8-1 is a flow chart illustrating a method for manufacturing an array substrate according to some embodiments of the present disclosure;
Fig. 8-2 is a structural schematic view of forming a source/drain metal thin film according to embodiments of the present disclosure;
Fig. 8-3 is a structural schematic view of forming a first source/drain metal pattern and a second source/drain metal pattern according to embodiments of the present disclosure;
Fig. 8-4 is a structural schematic view of forming a passivation layer according to embodiments of the present disclosure;

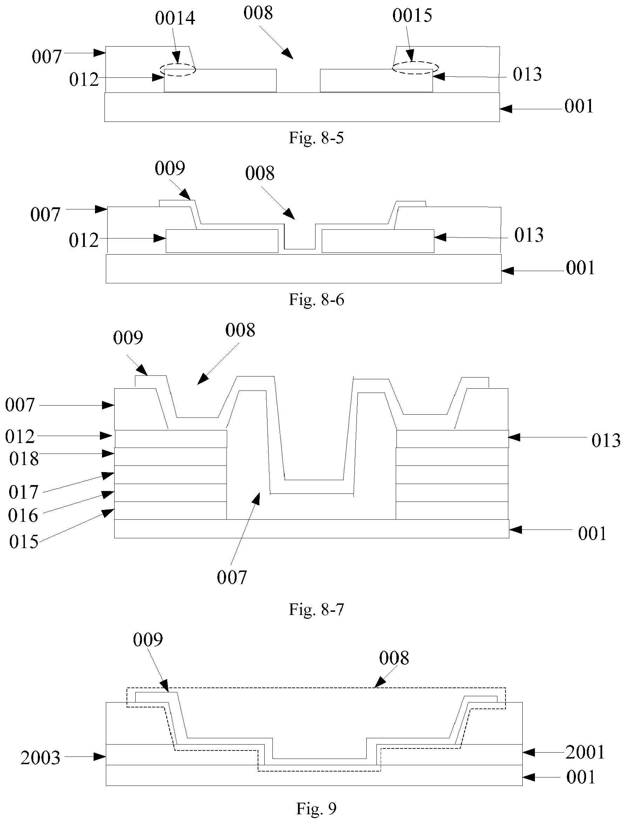

Fig. 8-5 is a structural schematic view of forming a passivation layer pattern according to embodiments of the present disclosure;
Fig. 8-6 is a structural schematic view of forming a jumper wire film according to embodiments of the present disclosure;
Fig. 8-7 is a structural schematic view of the array substrate corresponding to Fig. 8-1; and
Fig. 9 is a structural schematic view of an array substrate according to embodiments of the present disclosure.

Particular embodiments of the present disclosure have been illustrated in the above drawings, which will be described in more detail hereinafter. These drawings and written descriptions are not provided to limit the scope of the present disclosure in any sense, rather, they are provided to convey the concept of the present disclosure to those skilled in the art by referring to particular embodiments.

### DETAILED DESCRIPTION

Hereinafter, embodiments of the present disclosure will be described in further detail with reference to the accompanying drawings, such that the objective, implementations and advantages of the present disclosure may be further clear.

Unless otherwise defined, all technical or scientific terms used herein are to be interpreted as customary in the art to which the present disclosure belongs. Terms such as "first", "second", and the like used in the description and the claims of the present disclosure do not indicate any order, quantity or importance, instead, they are just used to distinguish different components. Likewise, terms such as "a" or "an" or the like are not intended to limit the quantity, but to indicate the presence of at least one. Terms such as "connect" or "connected with" or the like are not limited to physical or mechanical connection, but may include electrical connection, either directly or indirectly. Terms such as "upper", "lower", "left", "right" and the like are used to indicate relative positional relations, and the relative positional relation will change correspondingly as the absolute position of the described object changes.

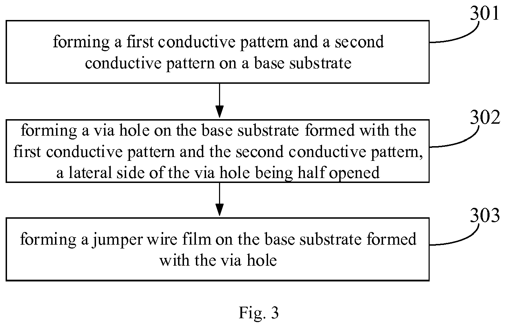

Embodiments of the present disclosure provide a method for manufacturing an array substrate. As illustrated in Fig. 3, the method includes the steps that follow.

In step 301, a first conductive pattern and a second conductive pattern are formed on a base substrate.

In step 302, a via hole is formed on the base substrate formed with the first conductive pattern and the second conductive pattern, and a lateral side of the via hole is half opened.

In step 303, a jumper wire film is formed on the base substrate formed with the via hole.

Accordingly, according to the method for manufacturing the array substrate in the embodiments of the present disclosure, it is possible to form a first conductive pattern and a second conductive pattern on a base substrate, form a via hole having a half opened lateral side on the base substrate formed with the first conductive pattern and the second conductive pattern, and form a jumper wire film on the base substrate formed with the via hole, thereby connecting the conductive patterns in different layers or the same layer using the jumper wire film. In comparison to the related art, it is possible to ensure a complete connection of the jumper wire film and a normal transmission of the signal, thereby improving display quality of the array substrate.

Further, the via hole is a bar shaped hole, and a lateral side in a length direction or a width direction of the bar shaped hole is opened. A size of the bar shaped hole along a direction of the lateral side that is opened is equal to or greater than 15 µm and equal to or smaller than 20 µm.

It should be noted that the first conductive pattern and the second conductive pattern may be positioned in different layers on the base substrate, or in the same layer on the base substrate. That is, the via hole formed in the embodiments of the present disclosure may be used to connect conductive patterns in different layers on the base substrate, such as connecting a source/drain metal pattern and a gate metal pattern, or connecting the source/drain metal pattern and the pixel electrode pattern, or the like; or may be used to connect conductive patterns in the same layer on the base substrate, such as connecting gate metal patterns, or connecting source/drain metal patterns, or the like. The jumper wire film may be formed of any conductive material of a metal pattern, a metal oxide pattern or the like, for example, the jumper wire film may be formed of Cu, A1 and the alloy thereof, or indium tin oxide (ITO) and the like.

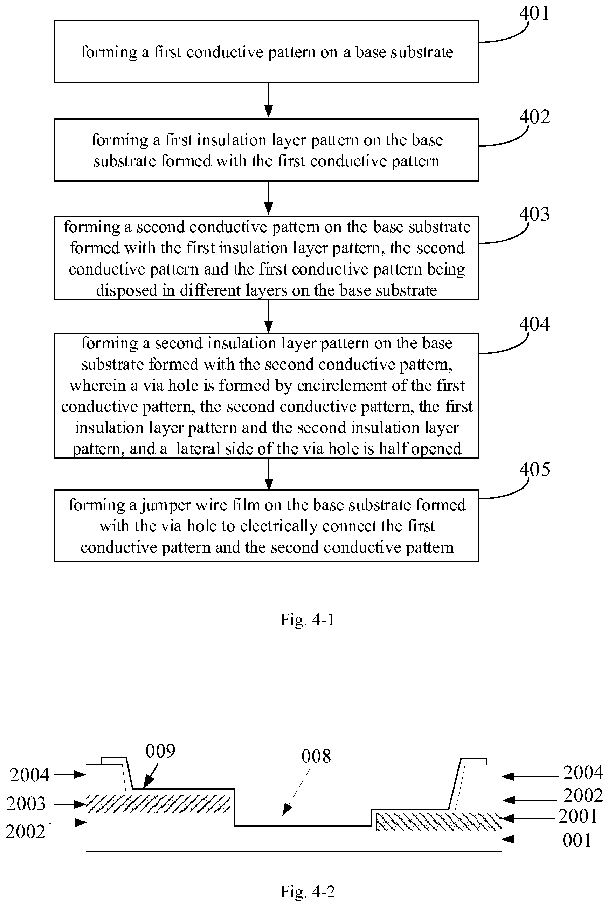

Embodiments of the present disclosure provide a method for manufacturing an array substrate, as illustrated in Fig. 4-1, the method includes the steps that follow.

In step 401, a first conductive pattern is formed on a base substrate.

In step 402, a first insulation layer pattern is formed on the base substrate formed with the first conductive pattern.

In step 403, a second conductive pattern is formed on the base substrate formed with the first insulation layer pattern, and the second conductive pattern and the first conductive pattern are disposed in different layers on the base substrate.

In step 404, a second insulation layer pattern is formed on the base substrate formed with the second conductive pattern. A via hole is formed by encirclement of the first conductive pattern, the second conductive pattern, the first insulation layer pattern and the second insulation layer pattern, and a lateral side of the via hole is half opened.

In step 405, a jumper wire film is formed on the base substrate formed with the via hole to electrically connect the first conductive pattern and the second conductive pattern.

Fig. 4-2 illustrates a structural schematic view of the array substrate. As illustrated in Fig. 4-2, the first conductive pattern 2001 is formed on the base substrate 001; the first insulation layer pattern 2002 is formed on the base substrate 001 formed with the first conductive pattern 2001; the second conductive pattern 2003 is formed on the base substrate 001 formed with the first insulation layer pattern 2002, and the second conductive pattern 2003 and the first conductive pattern 2001 are disposed in different layers on the base substrate 001. That is, positions of the second conductive pattern 2003 and the first conductive pattern 2001 on the base substrate 001 are located in different layers on the base substrate 001; and the second insulation layer pattern 2004 is formed on the base substrate 001 formed with the second conductive pattern 2003. The via hole 008 is formed by encirclement of the first conductive pattern 2001, the second conductive pattern 2003, the first insulation layer pattern 2002 and the second insulation layer pattern 2004, and a lateral side of the via hole 008 is half opened. The jumper wire film 009 is formed on the base substrate 001 formed with the via hole 008 to electrically connect the first conductive pattern 2001 and the second conductive pattern 2003. In an actual implementation, the first conductive pattern 2001 in Fig. 4-2 may be a gate metal pattern, the first insulation layer pattern 2002 may be a gate insulation pattern, the second conductive pattern 2003 may be a source/drain metal pattern, and the second insulation layer pattern 2004 may be a passivation layer pattern. Fig. 5-8 illustrates a structural schematic view of the formed array substrate.

Accordingly, according to the method for manufacturing the array substrate in the embodiments of the present disclosure, it is possible to form a second conductive pattern on a base substrate formed with a first conductive pattern, form a via hole having a half opened lateral side on the base substrate formed with the second conductive pattern, and form a jumper wire film on the base substrate formed with the via hole, thereby connecting the conductive patterns in different layers using the jumper wire film. In comparison to the related art, it is possible to ensure a complete connection of the jumper wire film and a normal transmission of the signal, thereby improving display quality of the array substrate.

Embodiments of the present disclosure provide a method for manufacturing an array substrate, in said method, for example, the first conductive pattern is a gate metal pattern, and the second conductive pattern is a source/drain metal pattern. As illustrated in Fig. 5-1, the method may include the steps that follow.

In step 501, a gate metal pattern is formed on a base substrate.

As illustrated in Fig. 5-2, the gate metal pattern 002 is formed on the base substrate 001.

In step 502, a gate insulation layer is formed on the base substrate formed with the gate metal pattern.

As illustrated in Fig. 5-3, the gate insulation layer 003 is formed on the base substrate 001 formed with the gate metal pattern 002.

In step 503, the gate insulation layer is patterned to form a gate insulation pattern.

In particular, a gate insulation thin film, i.e., the gate insulation layer, is formed on the base substrate formed with the gate metal pattern, a photoresist is applied on the base substrate formed with the gate insulation thin film, a mask is used to expose the base substrate applied with the photoresist, and the exposed base substrate is developed and etched to form the gate insulation pattern. Fig. 5-4 illustrates a structural schematic view of the formed gate insulation pattern 004. In Fig. 5-4, the gate insulation pattern 004 includes a first sub pattern 0041 formed on the gate metal pattern 002 and a second sub pattern 0042 formed in a same layer with the gate metal pattern 002, a gap is formed between the gate metal pattern 002 and the second sub pattern 0042. As illustrated in Fig. 5-4, the gap is formed between the gate metal pattern 002 and the second sub pattern 0042 along a scan direction of the gate line (i.e., the direction indicated by the arrow u). The first sub pattern 0041 overlaps a part of the gate metal pattern 002 away from the second sub pattern 0042. As illustrated in Fig. 5-4, a length d1 of the first sub pattern 0041 along the gate line scan direction is smaller than a length d2 of the gate metal pattern 002 along the gate line scan direction. It should be noted that, a side of the first sub pattern 0041 parallel to a scan direction of the data line (not illustrated) may be collinear with an edge of the base substrate 001, or may be not collinear with the edge of the base substrate 001. For example, the side of the first sub pattern 0041 parallel to the data line scan direction is positioned at an inner side of the edge of the base substrate 001, as long as the first sub pattern 0041 may overlap an end of the gate metal pattern 002 adjacent to the edge of the base substrate 001 and extend to the upper surface portion of the gate metal pattern 002. The length d1 of the first sub pattern 0041 along the gate line scan direction equals to a length of the portion of the first sub pattern 0041 overlapped with the upper surface part of the gate metal pattern 002. The gate metal pattern 002 and the second sub pattern 0042 are in the same layer, and it may refer to that a position of the gate metal pattern 002 and a position of the second sub pattern 0042 are located in the same layer on the base substrate 001.

In step 504, a source/drain metal pattern is formed on the base substrate formed with the gate insulation pattern.

As illustrated in Fig. 5-5, the source/drain metal pattern 005 is formed on the base substrate 001 formed with the gate insulation pattern 004. The source/drain metal pattern 005 is formed in a same layer with the first sub pattern 0041, i.e., positions of the source/drain metal pattern 005 and the first sub pattern 0041 on the base substrate 001 are located in the same layer on the base substrate 001. A gap is formed between the source/drain metal pattern 005 and the first sub pattern 0041. Descriptions of other components in Fig. 5-5 may refer to those in Fig. 5-4.

In step 505, a passivation layer is formed on the base substrate formed with the source/drain metal pattern.

As illustrated in Fig. 5-6, a passivation layer 006 is formed on the base substrate 001 formed with the source/drain metal pattern 005. Descriptions of other components in Fig. 5-6 may refer to those in Fig. 5-5.

In step 506, the passivation layer is patterned to form a passivation layer pattern.

In particular, as illustrated in Fig. 5-7, the passivation layer is patterned using a mask to form a passivation layer pattern 007. For example, a photoresist is applied on the passivation layer, the mask is used to expose the base substrate applied with the photoresist, and the exposed base substrate is developed and etched to form the passivation layer pattern. At last, the remaining photoresist are peeled off to finish the patterning of the passivation layer.

The passivation layer pattern 007 includes a third sub pattern 0071 formed on the first sub pattern 0041 and a fourth sub pattern 0072 formed on the source/drain metal pattern 005, the fourth sub pattern 0072 overlaps a part of the source/drain metal pattern 005 away from the first sub pattern 0041. For example, in Fig. 5-7, a length d6 of the fourth sub pattern 0072 along the gate line scan direction (i.e., the direction indicated by the arrow u) is smaller than a length d3 of the source/drain metal pattern 005 along the gate line scan direction. As illustrated in Fig. 5-7, the via hole 008 is formed by collective encirclement of a part of the gate metal pattern 002 that is not overlapped with the first sub pattern 0041 of the gate insulation layer, a part of the source/drain metal pattern 005 that is not overlapped with the fourth sub pattern 0072 of the passivation layer, the gate insulation pattern 004 and the passivation layer pattern 007. In Fig. 5-7, reference numeral 0042 indicates the second sub pattern.

In step 507, a jumper wire film is formed on the base substrate formed with the via hole to electrically connect the gate metal pattern and the source/drain metal pattern.

As illustrated in Fig. 5-8, the jumper wire film 009 is formed on the base substrate 001 formed with the via hole 008 to electrically connect the gate metal pattern 002 and the source/drain metal pattern 005. Descriptions of other components in Fig. 5-8 may refer to those in Fig. 5-7. For example, the jumper wire film 009 may be an ITO film.

Fig. 5-9 illustrates a plane view of the via hole. As illustrated in Fig. 5-9, the via hole 008 is a bar shaped hole, and a lateral side of the via hole is half opened. For example, a lateral side in the width direction (e.g., the direction indicated by the arrow f) of the bar shaped hole is opened, and the lateral side in the length direction (e.g., the direction indicated by the arrow e) of the bar shaped hole is not opened. A width b of the bar shaped hole is equal to or greater than 15 µm and equal to or smaller than 20 µm. The arrow v indicates a scan direction of the data line. It should be noted that, the length direction and the width direction in embodiments of the present disclosure are not absolute directions, rather, they are provided to schematically mark the structural diagram.

It should be further noted that, Fig. 5-8 is a cross sectional view taken along a part B-B' of the array substrate illustrated in Fig. 5-9. Fig. 5-10 is a cross sectional view taken along part a C-C' of the array substrate illustrated in Fig. 5-9. Fig. 5-10 illustrates the base substrate 001, the gate insulation pattern 004, the source/drain metal pattern 005, the passivation layer pattern 007 and the jumper wire film 009. Fig. 5-11 is a cross sectional view taken along a part D-D' of the array substrate illustrated in Fig. 5-9, and Fig. 5-11 illustrates the base substrate 001, the gate metal pattern 002, the gate insulation pattern 004, the passivation layer pattern 007 and the jumper wire film 009.

Accordingly, according to the method for manufacturing the array substrate in the embodiments of the present disclosure, it is possible to form a source/drain metal pattern on a base substrate formed with a gate metal pattern, form a via hole having a half opened lateral side on the base substrate formed with the source/drain metal pattern, and form a jumper wire film on the base substrate formed with the via hole, thereby connecting the conductive patterns in different layers using the jumper wire film. In comparison to the related art, it is possible to ensure a complete connection of the jumper wire film and a normal transmission of the signal, thereby improving display quality of the array substrate.

Embodiments of the present disclosure provide a method for manufacturing an array substrate. As illustrated in Fig. 6-1, the method includes the steps that follow.

In step 601, a first conductive pattern and a second conductive pattern are formed on a base substrate, and the second conductive pattern and the first conductive pattern are formed in a same layer on the base substrate.

In step 602, a first insulation layer pattern is formed on the base substrate formed with the first conductive pattern and the second conductive pattern. A via hole is formed by encirclement of the first conductive pattern, the second conductive pattern and the first insulation layer pattern, and a lateral side of the via hole is half opened.

In step 603, a jumper wire film is formed on the base substrate formed with the via hole to electrically connect the first conductive pattern and the second conductive pattern.

Fig. 6-2 illustrates a structural schematic view of the array substrate. As illustrated in Fig. 6-2, the first conductive pattern 2001 and the second conductive pattern 2003 are formed on the base substrate 001. The second conductive pattern 2003 and the first conductive pattern 2001 are formed in a same layer on the base substrate 001. That is, positions of the first conductive pattern 2001 and the second conductive pattern 2003 on the base substrate 001 are located in the same layer on the base substrate 001. The first insulation layer pattern 2002 is formed on the base substrate 001 formed with the first conductive pattern 2001 and the second conductive pattern 2003. The via hole 008 is formed by encirclement of the first conductive pattern 2001, the second conductive pattern 2003 and the first insulation layer pattern 2002, and a lateral side of the via hole 008 is half opened. The jumper wire film 009 is formed on the base substrate 001 formed with the via hole 008 to electrically connect the first conductive pattern 2001 and the second conductive pattern 2003. In an actual implementation, the first conductive pattern 2001 in Fig. 6-2 may be a first gate metal pattern, the second conductive pattern 2003 may be a second gate metal pattern, and the first insulation layer pattern 2002 may be a gate insulation pattern. Fig. 7-6 illustrates a structural schematic view of the formed array substrate. In Fig. 7-6, a data line pattern may be formed in the same layer between the first gate metal pattern and the second gate pattern, and in addition to overlapping a part of the first gate metal pattern away from the second gate metal pattern and overlapping a part of the second gate metal pattern away from the first gate metal pattern, the gate insulation pattern further overlaps a part between the data line pattern, the first gate metal pattern and the second gate metal pattern as well as a surface of the data line pattern, such that the first gate metal pattern, the second gate metal pattern and the data line pattern are insulated from one another. Accordingly, a via hole having a recessed cross section may be formed by encirclement of the first gate metal pattern, the second gate metal pattern and the gate insulation pattern. Fig. 6-3 illustrates the first gate metal pattern 010, the second gate metal pattern 011, the data line pattern 014, the gate insulation pattern 004, the base substrate 001, the via hole 008, and the jumper wire film 009. It should be noted that the array substrate structure illustrated in Fig. 6-3 is not the only structure of the array substrate formed with a first gate metal pattern, a second gate metal pattern and a data line pattern. In actual implementation, in addition to the above mentioned first gate metal pattern, the second gate metal pattern, the data line pattern and the gate insulation pattern, the array substrate may further include other components, which are not limited herein.

Of course, the via hole structure provided for connecting two parts of conductive patterns in the same layer may be formed in other forms, such as patching of various disconnected lines, other design of crossing lines in the same layer, or the like, which will not be described in detail herein.

Accordingly, according to the method for manufacturing the array substrate in the embodiments of the present disclosure, it is possible to form a first conductive pattern and a second conductive pattern on a base substrate, form a via hole having a half opened lateral side on the base substrate formed with the first conductive pattern and the second conductive pattern, and form a jumper wire film on the base substrate formed with the via hole, thereby connecting the conductive patterns in the same layer using the jumper wire film. In comparison to the related art, it is possible to ensure a complete connection of the jumper wire film and a normal transmission of the signal, thereby improving display quality of the array substrate.

Embodiments of the present disclosure provide a method for manufacturing an array substrate, in said method, for example, the first conductive pattern is a first gate metal pattern, and the second conductive pattern is a second gate metal pattern. As illustrated in Fig. 7-1, the method may include the steps that follow.

In step 701, a gate metal thin film is formed on a base substrate, and the gate metal thin film is patterned to form a first gate metal pattern and a second gate metal pattern in the same layer.

As illustrated in Fig. 7-2, the gate metal thin film 0010 is formed on the base substrate 001. As illustrated in Fig. 7-3, the base substrate 001 formed with the gate metal thin film is patterned to form the first gate metal pattern 010 and the second gate metal pattern 011. In particular, a photoresist is applied on the base substrate formed with the gate metal thin film, a mask is used to expose the base substrate applied with the photoresist, and the exposed base substrate is developed and etched to form the first gate metal pattern and the second gate metal pattern.

In step 702, a gate insulation layer is formed on the base substrate formed with the first gate metal pattern and the second gate metal pattern.

As illustrated in Fig. 7-4, the gate insulation layer 003 is formed on the base substrate 001 formed with the first gate metal pattern 010 and the second gate metal pattern 011.

In step 703, the gate insulation layer is patterned to form a gate insulation pattern.

As illustrated in Fig. 7-5, the gate insulation layer is patterned using a mask to form the gate insulation pattern 004. In particular, a photoresist is applied on the base substrate formed with the gate insulation layer, a mask is used to expose the base substrate applied with the photoresist, and the exposed base substrate is developed and etched to form the gate insulation pattern. In this embodiment, the gate insulation pattern 004 overlaps a part of the first gate metal pattern 010 away from the second gate metal pattern 011 (e.g., the region indicated by reference numeral 0011), and overlaps a part of the second gate metal pattern 011 away from the first gate metal pattern 010 (e.g., the region indicated by reference numeral 0012). The via hole 008 is formed by collective encirclement of a part of the first gate metal pattern 010 that is not overlapped with the gate insulation pattern 004, a part of the second gate metal pattern 011 that is not overlapped with the gate insulation pattern 004, and the gate insulation pattern 004, and a lateral side of the via hole 008 is half opened. In this embodiment, the term "half opened" means that the lateral side of the bar shaped hole in the width direction is opened. The structure of the via hole may refer to the description of Fig. 5-9, which will not be repeated herein.

In step 704, a jumper wire film is formed on the base substrate formed with the via hole to electrically connect the first gate metal pattern and the second gate metal pattern.

As illustrated in Fig. 7-6, the jumper wire film 009 is formed on the base substrate 001 formed with the via hole 008 to electrically connect the first gate metal pattern 010 and the second gate metal pattern 011. For example, the jumper wire film 009 may be an ITO film. The reference numeral 004 indicates the gate insulation pattern.

In addition, processes, such as forming an intrinsic semiconductor thin film, a doped semiconductor thin film and a source/drain metal thin film on the base substrate, patterning the source/drain metal thin film, the doped semiconductor thin film and the intrinsic semiconductor thin film to form the data line, the source/drain electrode, and the active layer, and forming the passivation layer pattern, may refer to the related prior art, which will not be repeated herein.

Accordingly, according to the method for manufacturing the array substrate in the embodiments of the present disclosure, it is possible to form a first gate metal pattern and a second gate metal pattern on a base substrate, form a via hole having a half opened lateral side on the base substrate formed with the first gate metal pattern and the second gate metal pattern, and form a jumper wire film on the base substrate formed with the via hole, thereby connecting the conductive patterns in the same layer using the jumper wire film. In comparison to the related art, it is possible to ensure a complete connection of the jumper wire film and a normal transmission of the signal, thereby improving display quality of the array substrate.

Embodiments of the present disclosure provide a method for manufacturing an array substrate, in said method, for example, the first conductive pattern is a first source/drain metal pattern, and the second conductive pattern is a second source/drain metal pattern. As illustrated in Fig. 8-1, the method may include the steps that follow.

In step 801, a source/drain metal thin film is formed on a base substrate, and the source/drain metal thin film is patterned to form a first source/drain metal pattern and a second source/drain metal pattern in the same layer.

As illustrated in Fig. 8-2, the source/drain metal thin film 0013 is formed on the base substrate 001. As illustrated in Fig. 8-3, the base substrate 001 formed with the source/drain metal thin film is patterned to form the first source/drain metal pattern 012 and the second source/drain metal pattern 013. In particular, a photoresist is applied on the base substrate formed with the source/drain metal thin film, a mask is used to expose the base substrate applied with the photoresist, and the exposed base substrate is developed and etched to form the first source/drain metal pattern and the second source/drain metal pattern.

In step 802, a passivation layer is formed on the base substrate formed with the first source/drain metal pattern and the second source/drain metal pattern.

As illustrated in Fig. 8-4, the passivation layer 006 is formed on the base substrate 001 formed with the first source/drain metal pattern 012 and the second source/drain metal pattern 013.

In step 803, the passivation layer is patterned to form a passivation layer pattern.

As illustrated in Fig. 8-5, the passivation layer is patterned to form the passivation layer pattern 007. In particular, a photoresist is applied on the base substrate formed with the passivation layer, a mask is used to expose the base substrate applied with the photoresist, and the exposed base substrate is developed and etched to form the passivation layer pattern. The passivation layer pattern 007 overlaps a part of the first source/drain metal pattern 012 away from the second source/drain metal pattern 013 (e.g., the region indicated by reference numeral 0014), and overlaps a part of the second source/drain metal pattern 013 away from the first source/drain metal pattern 012 (e.g., the region indicated by reference numeral 0015). The via hole 008 is formed by collective encirclement of a part of the first source/drain metal pattern 012 that is not overlapped with the passivation layer pattern 007, a part of the second source/drain metal pattern 013 that is not overlapped with the passivation layer pattern 007, and the passivation layer pattern 007, and a lateral side of the via hole 008 is half opened. In this embodiment, the term "half opened" means that the lateral side of the bar shaped hole in the width direction is opened.

In step 804, a jumper wire film is formed on the base substrate formed with the via hole to electrically connect the first gate source/drain pattern and the second source/drain metal pattern.

As illustrated in Fig. 8-6, the jumper wire film 009 is formed on the base substrate 001 formed with the via hole 008 to electrically connect the first source/drain metal pattern 012 and the second source/drain metal pattern 013. For example, the jumper wire film 009 may be an ITO film. The reference numeral 007 indicates the passivation layer pattern. It should be noted that, prior to forming the first source/drain metal pattern and the second source/drain metal pattern on the base substrate, a gate metal thin film, a gate insulation film, an intrinsic semiconductor thin film, and a doped semiconductor thin film may be formed on the base substrate. Accordingly, in addition to overlapping the part of the first source/drain metal pattern away from the second source/drain metal pattern and overlapping a part of the second source/drain metal pattern away from the first source/drain metal pattern, the passivation layer pattern further overlaps a part between the first source/drain metal pattern and the second source/drain metal pattern. As illustrated in Fig. 8-7, Fig. 8-7 illustrates the gate metal thin film 015, the gate insulation thin film 016, the intrinsic semiconductor thin film 017, the doped semiconductor thin film 018, the first source/drain metal pattern 012, the second source/drain metal pattern 013, the passivation layer pattern 007, the via hole 008, the jumper wire film 009 and the base substrate 001.

It should be noted that, processes, such as forming the gate metal thin film, the gate insulation thin film, the intrinsic semiconductor thin film, and the doped semiconductor thin film on the base substrate, and patterning the doped semiconductor thin film, the intrinsic semiconductor thin film, the gate insulation thin film and the gate metal thin film, may refer to the related prior art, which will not be repeated herein.

Accordingly, according to the method for manufacturing the array substrate in the embodiments of the present disclosure, it is possible to form a first source/drain metal pattern and a second source/drain metal pattern on a base substrate, form a via hole having a half opened lateral side on the base substrate formed with the first source/drain metal pattern and the second source/drain metal pattern, and form a jumper wire film on the base substrate formed with the via hole, thereby connecting the conductive patterns in the same layer using the jumper wire film. In comparison to the related art, it is possible to ensure a complete connection of the jumper wire film and a normal transmission of the signal, thereby improving display quality of the array substrate.

In addition, it should be noted that via hole formed by the method in the related art generally has a diameter of 10 µm. The via hole is formed with a smaller opening and is a blind circular hole or a blind square hole. Such a via hole has a poor undercut resistance and has a high risk of undercut. Meanwhile, the ITO film is relative thin. Accordingly, it is possible that the ITO film is disconnected and the signal cannot be transmitted normally, causing a certain progressive. Herein, the term "progressive" means that the display device is defect-free during the test of the display device performed by the manufacturer, while certain display defects are exposed when the display device is delivered to a user. In the method for manufacturing an array substrate according to embodiments of the present disclosure, the via hole may have a width of 15 to 20 µm, thereby increasing the opening of the via hole. In addition, the via hole is a half opened hole, and thus may increase the undercut resistance ability to a large extent. Accordingly, the risk of undercut may be lowered, and it is possible to ensure a complete connection of the jumper wire film and a normal transmission of the signal. According the above method, it is unnecessary to add additional exposing process, and thus it is simple and easily performable, thereby having a high applicability. In addition, the via hole formed using this method may further save the space in the array substrate.

In addition, it should be noted that the via hole is a key part of the jumper wire design. The same etching process has different etching rates with respect to different materials, and even with respect to the same material, the etching rates at the boundary of the material and inside the material will be different. At the same time, in the prior art, at least four to five exposing and etching processes are required during manufacturing the array substrate, and thus the over etching may cause undercut. When there is high risk of undercut, display quality of the array may be deteriorated, and sometimes may cause the failure of the display device. According to embodiments of the present disclosure, metals at the position of the jumper wire may be exposed by the exposing and etching process of the passivation layer, and different conductive patterns may be connected using an ITO film, thereby improving the display quality of the array display and in turn improving image quality of the display device.

Embodiments of the present disclosure provide an array substrate. As illustrated in Fig. 9, the array substrate includes: a base substrate 001; a first conductive pattern 2001 and a second conductive pattern 2003 formed on the base substrate 001; a via hole 008 formed on the base substrate 001 formed with the first conductive pattern 2001 and the second conductive pattern 2003, a lateral side of the via hole 008 being half opened; and a jumper wire film 009 formed on the base substrate 001 formed with the via hole 008. It should be noted that the area surrounded by the dashed line in Fig. 9 is the via hole 008, and in other drawings (e.g., Fig. 5-8), the via hole may be described with reference to the identifier of the via hole illustrated in Fig. 9.

Accordingly, according to the array substrate in the embodiments of the present disclosure, a first conductive pattern and a second conductive pattern are formed on a base substrate, a via hole having a half opened lateral side is formed on the base substrate formed with the first conductive pattern and the second conductive pattern, and a jumper wire film is formed on the base substrate formed with the via hole, thereby connecting the conductive patterns in different layers or the same layer using the jumper wire film. In comparison to the related art, it is possible to ensure a complete connection of the jumper wire film and a normal transmission of the signal, thereby improving display quality of the array substrate.

Optionally, the via hole is a bar shaped hole, and a lateral side in a length direction or a width direction of the bar shaped hole is opened. A size of the bar shaped hole along a direction of the lateral side that is opened is equal to or greater than 15 µm and equal to or smaller than 20 µm.

It should be noted that, the first conductive pattern and the second conductive layer may be positioned in different layers on the base substrate, or may be positioned in the same layer on the base substrate. As illustrated in Fig. 9, the first conductive pattern 2001 and the second conductive pattern 2003 are positioned in the same layer on the base substrate, i.e., positions of the first conductive pattern 2001 and the second conductive pattern 2003 on the base substrate are located in the same layer on the base substrate. In the embodiments of the present disclosure, the via hole may be formed for connecting conductive patterns in different layers on the base substrate, e.g., connecting the source/drain metal pattern and the gate metal patterns; or may be formed for connecting conductive patterns in the same layer on the base substrate, e.g., connecting the gate metal patterns, or connecting the source/drain metal patterns, or the like.

Embodiments of the present disclosure provide an array substrate, as illustrated in Fig. 4-2, the array substrate includes: a base substrate 001; a first conductive pattern 2001 formed on the base substrate 001; a first insulation layer pattern 2002 formed on the base substrate 001 formed with the first conductive pattern 2001; a second conductive pattern 2003 formed on the base substrate 001 formed with the first insulation layer pattern 2002, the second conductive pattern 2003 and the first conductive pattern 2001 being disposed in different layers on the base substrate 001; a second insulation layer pattern 2004 formed on the base substrate 001 formed with the second conductive pattern 2003; a via hole 008 formed by encirclement of the first conductive pattern 2001, the second conductive pattern 2003, the first insulation layer pattern 2002 and the second insulation layer pattern 2004, a lateral side of the via hole 008 being half opened; and a jumper wire film 009 formed on the base substrate 001 formed with the via hole 008 to electrically connect the first conductive pattern 2001 and the second conductive pattern 2003.

Accordingly, according to the array substrate in the embodiments of the present disclosure, a second conductive pattern is formed on a base substrate formed with a first conductive pattern, a via hole having a half opened lateral side is formed on the base substrate formed with the second conductive pattern, and a jumper wire film is formed on the base substrate formed with the via hole, thereby connecting the conductive patterns in different layers using the jumper wire film. In comparison to the related art, it is possible to ensure a complete connection of the jumper wire film and a normal transmission of the signal, thereby improving display quality of the array substrate.

Embodiments of the present disclosure provide an array substrate, as illustrated in Fig. 5-8, the array substrate includes: a base substrate 001; a gate metal pattern 002 formed on the base substrate 001; a gate insulation pattern 004 formed on the base substrate 001 formed with the gate metal pattern 002; a source/drain metal pattern 005 formed on the base substrate 001 formed with the gate insulation pattern 004; a passivation layer pattern 007 formed on the base substrate 001 formed with the source/drain metal pattern 005; a via hole 008 formed by collective encirclement of a part of the gate metal pattern 002 that is not overlapped with a first sub pattern 0041 of the gate insulation layer, a part of the source/drain metal pattern 005 that is not overlapped with a fourth sub pattern 0072 of the passivation layer, the gate insulation pattern 004 and the passivation layer pattern 007; and a jumper wire film 009 formed on the base substrate 001 formed with the via hole 008 to electrically connect the gate metal pattern 002 and the source/drain metal pattern 005.

In the present embodiment, the gate insulation pattern 004 includes a first sub pattern 0041 formed on the gate metal pattern 002 and a second sub pattern 0042 formed in a same layer with the gate metal pattern 002, a gap is formed between the gate metal pattern 002 and the second sub pattern 0042, and the first sub pattern 0041 overlaps a part of the gate metal pattern 002 away from the second sub pattern 0042.

As illustrated in Fig. 5-8, the source/drain metal pattern 005 and the first sub pattern 0041 are positioned in the same layer, that is, the positions of the source/drain metal pattern 005 and the first sub pattern 0041 on the base substrate 001 are located in the same layer on the base substrate 001. A gap is formed between the source/drain metal pattern 005 and the first sub pattern 0041. The passivation layer pattern 007 includes a third sub pattern 0071 formed on the first sub pattern 0041 and a fourth sub pattern 0072 formed on the source/drain metal pattern 005, the fourth sub pattern 0072 overlaps a part of the source/drain metal pattern 005 away from the first sub pattern 0041. The via hole 008 is formed by collective encirclement of a part of the gate metal pattern 002 that is not overlapped with the first sub pattern 0041 of the gate insulation layer, a part of the source/drain metal pattern 005 that is not overlapped with the fourth sub pattern 0072 of the passivation layer, the gate insulation pattern 004 and the passivation layer pattern 007.

Accordingly, according to the array substrate in the embodiments of the present disclosure, a source/drain metal pattern is formed on a base substrate formed with a gate metal pattern, a via hole having a half opened lateral side is formed on the base substrate formed with the source/drain metal pattern, and a jumper wire film is formed on the base substrate formed with the via hole, thereby connecting the conductive patterns in different layers using the jumper wire film. In comparison to the related art, it is possible to ensure a complete connection of the jumper wire film and a normal transmission of the signal, thereby improving display quality of the array substrate.

Embodiments of the present disclosure provide an array substrate, as illustrated in Fig. 6-2, the array substrate includes: a base substrate 001; a first conductive pattern 2001 and a second conductive pattern 2003 formed on the base substrate 001, the first conductive pattern 2001 and the second conductive pattern 2003 being in the same layer on the base substrate 001, i.e., the positions of the first conductive pattern 2001 and the second conductive pattern 2003 on the base substrate are located in the same layer on the base substrate 001; a first insulation layer pattern 2002 formed on the base substrate 001 formed with the first conductive pattern 2001 and the second conductive pattern 2003; a via hole 008 formed by encirclement of the first conductive pattern 2001, the second conductive pattern 2003 and the first insulation layer pattern 2002, a lateral side of the via hole 008 being half opened; a jumper wire film 009 is formed on the base substrate 001 formed with the via hole 008 to electrically connect the first conductive pattern 2001 and the second conductive pattern 2003.

Illustratively, the first conductive pattern 2001 is a first gate metal pattern, the second conductive pattern 2003 is a second gate metal pattern, and the first insulation layer pattern 2002 is a gate insulation pattern. Alternatively, the first conductive pattern 2001 is a first source/drain metal pattern, the second conductive pattern 2003 is a second source/drain metal pattern, and the first insulation layer pattern 2002 is a passivation layer pattern.

In particular, in the case where the first conductive pattern 2001 is a first gate metal pattern, the second conductive pattern 2003 is a second gate metal pattern, and the first insulation layer pattern 2002 is a gate insulation pattern, as illustrated in Fig. 7-5, the gate insulation pattern 004 overlaps a part of the first gate metal pattern 010 away from the second gate metal pattern 011 and a part of the second gate metal pattern 011 away from the first gate metal pattern 010, and the via hole 008 is formed by collective encirclement of a part of the first gate metal pattern 010 that is not overlapped with the gate insulation layer 004, a part of the second gate metal pattern 011 that is not overlapped with the gate insulation pattern 004, and the gate insulation pattern 004.

In the case wherein the first conductive pattern 2001 is a first source/drain metal pattern, the second conductive pattern 2003 is a second source/drain metal pattern, and the first insulation layer pattern 2002 is a passivation layer pattern, as illustrated in Fig. 8-5, the passivation layer pattern 007 overlaps a part of the first source/drain metal pattern 012 away from the second source/drain metal pattern 013 and a part of the second source/drain metal pattern 013 away from the first source/drain metal pattern 012, and the via hole 008 is formed by collective encirclement of a part of the first source/drain metal pattern 012 that is not overlapped with the passivation layer pattern 007, a part of the second source/drain metal pattern 013 that is not overlapped with the passivation layer pattern 007, and the passivation layer pattern 007.

Accordingly, according to the array substrate in the embodiments of the present disclosure, a via hole having a half opened lateral side is formed on the base substrate formed with the first conductive pattern and the second conductive pattern, and a jumper wire film is formed on the base substrate formed with the via hole, thereby connecting the conductive patterns in the same layer using the jumper wire film. In comparison to the related art, it is possible to ensure a complete connection of the jumper wire film and a normal transmission of the signal, thereby improving display quality of the array substrate.

Embodiments of the present disclosure provide a display panel including the array substrate illustrated in Fig. 4-2, Fig. 6-2 or Fig. 9.

Embodiments of the present disclosure provide a display device including the above display panel. The display device may be an LCD television, a cell phone, a tablet computer, a navigation device, or the like. In the display panel included in the display device, a jumper wire film on a half opened via hole is used to connect conductive patterns in the same layer or in different layers. In comparison to the related art, it is possible to ensure a complete connection of the jumper wire film and a normal transmission of the signal, thereby improving display quality of the display device.

Preferred embodiments of the present disclosure are described above, which do not limit the present disclosure. All the modifications, alternatives and improvements without departing from the sprite and principle of the present disclosure fall within the protection scope of the present disclosure.

## Claims

1. A method for manufacturing an array substrate, comprising:
forming a first conductive pattern and a second conductive pattern on a base substrate;
forming a via hole on the base substrate formed with the first conductive pattern and the second conductive pattern, a lateral side of the via hole being half opened; and
forming a jumper wire film on the base substrate formed with the via hole.

2. The method according to claim 1, wherein the via hole is a bar shaped hole, and a lateral side in a length direction or a width direction of the bar shaped hole is opened.

3. The method according to claim 2, wherein a size of the bar shaped hole along a direction of the lateral side that is opened is equal to or greater than 15 µm and equal to or smaller than 20 µm.

4. The method according to claim 1, further comprising:
forming the first conductive pattern on the base substrate;
forming a first insulation layer pattern on the base substrate formed with the first conductive pattern;
forming the second conductive pattern on the base substrate formed with the first insulation layer pattern, the second conductive pattern and the first conductive pattern being disposed in different layers on the base substrate;
forming a second insulation layer pattern on the base substrate formed with the second conductive pattern;
forming the via hole by encirclement of the first conductive pattern, the second conductive pattern, the first insulation layer pattern and the second insulation layer pattern; and
forming the jumper wire film on the base substrate formed with the via hole to electrically connect the first conductive pattern and the second conductive pattern.

5. The method according to claim 4, wherein the first conductive pattern is a gate metal pattern, and the second conductive pattern is a source/drain metal pattern,
wherein the forming a first insulation layer pattern on the base substrate formed with the first conductive pattern comprises:
forming a gate insulation layer on the base substrate formed with the gate metal pattern; and
patterning the gate insulation layer to form a gate insulation pattern,
wherein the forming a second conductive pattern on the base substrate formed with the first insulation layer pattern comprises:
forming the source/drain metal pattern on the base substrate formed with the gate insulation pattern,
wherein the forming a second insulation layer pattern on the base substrate formed with the second conductive pattern comprises:
forming a passivation layer on the base substrate formed with the source/drain metal pattern; and
patterning the passivation layer to form a passivation layer pattern.

6. The method according to claim 5, wherein
the gate insulation pattern comprises a first sub pattern formed on the gate metal pattern and a second sub pattern formed in a same layer with the gate metal pattern, a gap is formed between the gate metal pattern and the second sub pattern, and the first sub pattern overlaps a part of the gate metal pattern away from the second sub pattern.

7. The method according to claim 6, wherein
the source/drain metal pattern is formed in a same layer with the first sub pattern, and a gap is formed between the source/drain metal pattern and the first sub pattern.

8. The method according to claim 7, wherein
the passivation layer pattern comprises a third sub pattern formed on the first sub pattern and a fourth sub pattern formed on the source/drain metal pattern, the fourth sub pattern overlaps a part of the source/drain metal pattern away from the first sub pattern, and the via hole is formed by collective encirclement of a part of the gate metal pattern that is not overlapped with the first sub pattern of the gate insulation layer, a part of the source/drain metal pattern that is not overlapped with the fourth sub pattern of the passivation layer, the gate insulation pattern and the passivation layer pattern.

9. The method according to claim 1, further comprising:
forming the first conductive pattern and the second conductive pattern on the base substrate, the second conductive pattern and the first conductive pattern being formed in a same layer on the base substrate;
forming a first insulation layer pattern on the base substrate formed with the first conductive pattern and the second conductive pattern;
forming the via hole by encirclement of the first conductive pattern, the second conductive pattern and the first insulation layer pattern; and
forming the jumper wire film on the base substrate formed with the via hole to electrically connect the first conductive pattern and the second conductive pattern.

10. The method according to claim 9, wherein the first conductive pattern is a first gate metal pattern, the second conductive pattern is a second gate metal pattern, and the method further comprises:
forming a gate metal thin film on the base substrate, and patterning the gate metal thin film to form the first gate metal pattern and the second gate metal pattern in a same layer;
forming a gate insulation layer on the base substrate formed with the first gate metal pattern and the second gate metal pattern;
patterning the gate insulation layer to form a gate insulation pattern, the gate insulation pattern overlapping a part of the first gate metal pattern away from the second gate metal pattern and overlapping a part of the second gate metal pattern away from the first gate metal pattern;
forming the via hole by collective encirclement of a part of the first gate metal pattern that is not overlapped with the gate insulation pattern, a part of the second gate metal pattern that is not overlapped with the gate insulation pattern, and the gate insulation pattern; and
forming the jumper wire film on the base substrate formed with the via hole to electrically connect the first gate metal pattern and the second gate metal pattern.

11. The method according to claim 9, wherein the first conductive pattern is a first source/drain metal pattern, the second conductive pattern is a second source/drain metal pattern, and the method further comprises:
forming a source/drain metal thin film on the base substrate, and patterning the source/drain metal thin film to form the first source/drain metal pattern and the second source/drain metal pattern in a same layer;
forming a passivation layer on the base substrate formed with the first source/drain metal pattern and the second source/drain metal pattern;
patterning the passivation layer to form a passivation layer pattern, the passivation layer pattern overlapping a part of the first source/drain metal pattern away from the second source/drain metal pattern and overlapping a part of the second source/drain metal pattern away from the first source/drain metal pattern;
forming the via hole by collective encirclement of a part of the first source/drain metal pattern that is not overlapped with the passivation layer pattern, a part of the second source/drain metal pattern that is not overlapped with the passivation layer pattern, and the passivation layer pattern; and
forming the jumper wire film on the base substrate formed with the via hole to electrically connect the first source/drain metal pattern and the second source/drain metal pattern.

12. An array substrate comprising:
a base substrate;
a first conductive pattern and a second conductive pattern formed on the base substrate;
a via hole formed on the base substrate formed with the first conductive pattern and the second conductive pattern, a lateral side of the via hole being half opened; and
a jumper wire film formed on the base substrate formed with the via hole.

13. The array substrate according to claim 12, wherein the via hole is a bar shaped hole, and a lateral side in a length direction or a width direction of the bar shaped hole is opened.

14. The array substrate according to claim 13, wherein a size of the bar shaped hole along a direction of the lateral side that is opened is equal to or greater than 15 µm and equal to or smaller than 20 µm.

15. The array substrate according to claim 12, wherein
the first conductive pattern is formed on the base substrate;
a first insulation layer pattern is formed on the base substrate formed with the first conductive pattern;
the second conductive pattern is formed on the base substrate formed with the first insulation layer pattern, the second conductive pattern and the first conductive pattern being disposed in different layers on the base substrate;
a second insulation layer pattern is formed on the base substrate formed with the second conductive pattern;
the via hole is formed by encirclement of the first conductive pattern, the second conductive pattern, the first insulation layer pattern and the second insulation layer pattern; and
the jumper wire film is formed on the base substrate formed with the via hole to electrically connect the first conductive pattern and the second conductive pattern.

16. The array substrate according to claim 15, wherein the first conductive pattern is a gate metal pattern, and the second conductive pattern is a source/drain metal pattern,
a gate insulation pattern is formed on the base substrate formed with the gate metal pattern;
the source/drain metal pattern is formed on the base substrate formed with the gate insulation pattern; and
a passivation layer pattern is formed on the base substrate formed with the source/drain metal pattern.

17. The array substrate according to claim 16, wherein
the gate insulation pattern comprises a first sub pattern formed on the gate metal pattern and a second sub pattern formed in a same layer with the gate metal pattern, a gap is formed between the gate metal pattern and the second sub pattern, and the first sub pattern overlaps a part of the gate metal pattern away from the second sub pattern.

18. The array substrate according to claim 17, wherein
the source/drain metal pattern is formed in a same layer with the first sub pattern, and a gap is formed between the source/drain metal pattern and the first sub pattern.

19. The array substrate according to claim 18, wherein
the passivation layer pattern comprises a third sub pattern formed on the first sub pattern and a fourth sub pattern formed on the source/drain metal pattern, the fourth sub pattern overlaps a part of the source/drain metal pattern away from the first sub pattern, and the via hole is formed by collective encirclement of a part of the gate metal pattern that is not overlapped with the first sub pattern of the gate insulation layer, a part of the source/drain metal pattern that is not overlapped with the fourth sub pattern of the passivation layer, the gate insulation pattern and the passivation layer pattern.

20. The array substrate according to claim 12, wherein
the first conductive pattern and the second conductive pattern are formed on the base substrate, and the second conductive pattern and the first conductive pattern are formed in a same layer on the base substrate;
a first insulation layer pattern is formed on the base substrate formed with the first conductive pattern and the second conductive pattern;
the via hole is formed by encirclement of the first conductive pattern, the second conductive pattern and the first insulation layer pattern; and
the jumper wire film is formed on the base substrate formed with the via hole to electrically connect the first conductive pattern and the second conductive pattern.

21. The array substrate according to claim 20, wherein the first conductive pattern is a first gate metal pattern, and the second conductive pattern is a second gate metal pattern,
the first gate metal pattern and the second gate metal pattern are formed on the base substrate;
a gate insulation pattern is formed on the base substrate formed with the first gate metal pattern and the second gate metal pattern, the gate insulation pattern overlaps a part of the first gate metal pattern away from the second gate metal pattern and overlaps a part of the second gate metal pattern away from the first gate metal pattern;
the via hole is formed by collective encirclement of a part of the first gate metal pattern that is not overlapped with the gate insulation pattern, a part of the second gate metal pattern that is not overlapped with the gate insulation pattern, and the gate insulation pattern; and
the jumper wire film is formed on the base substrate formed with the via hole to electrically connect the first gate metal pattern and the second gate metal pattern.

22. The array substrate according to claim 20, wherein the first conductive pattern is a first source/drain metal pattern, and the second conductive pattern is a second source/drain metal pattern,
the first source/drain metal pattern and the second source/drain metal pattern are formed on the base substrate;
a passivation layer pattern is formed on the base substrate formed with the first source/drain metal pattern and the second source/drain metal pattern, and the passivation layer pattern overlaps a part of the first source/drain metal pattern away from the second source/drain metal pattern and overlaps a part of the second source/drain metal pattern away from the first source/drain metal pattern, wherein the via hole is formed by collective encirclement of a part of the first source/drain metal pattern that is not overlapped with the passivation layer pattern, a part of the second source/drain metal pattern that is not overlapped with the passivation layer pattern, and the passivation layer pattern; and
the jumper wire film is formed on the base substrate formed with the via hole to electrically connect the first source/drain metal pattern and the second source/drain metal pattern.

23. A display panel comprising an array substrate according to any one of claims 12 to 22.

24. A display device comprising a display panel according to claim 23.
